# EUROPEAN PATENT APPLICATION

(11) **EP 4 757 564 A1**
(43) Date of publication of application: **10.06.2026**
(21) Application number: 25210041.7
(22) Date of filing: 21.10.2025
(51) Int. Cl.: H10N 50/01, H10N 50/10, H10N 50/80, H10B 61/00

(54) **MAGNETIC MEMORY DEVICE, METHOD OF MANUFACTURING THE MAGNETIC MEMORY DEVICE, AND MEMORY APPARATUS INCLUDING THE MAGNETIC MEMORY DEVICE**

(30) Priority: 03.12.2024 KR 20240177587; 05.09.2025 KR 20250126785
(71) Applicant: Samsung Electronics Co., Ltd., Suwon-si, Gyeonggi-do 16677 (KR)
(72) Inventor: KIM, Kwangseok, 16678 Suwon-si (KR); MIZUSAKI, Soichiro, 16678 Suwon-si (KR); OKADA, Atsushi, 16678 Suwon-si (KR); HASE, Naoki, 16678 Suwon-si (KR)
(74) Representative: Elkington and Fife LLP

(57) **Abstract**

Provided are a magnetic memory device, a method of manufacturing the magnetic memory device, and a memory apparatus including the magnetic memory device. The magnetic memory device includes a spin-orbit torque (SOT) generation layer configured to generate a SOT, a spin current transfer layer on a lower surface of the SOT generation layer, and a tunneling magnetoresistance layer on a lower surface of the spin current transfer layer and including a free layer, a tunnel barrier layer, and a pinned layer. The spin current transfer layer is configured to transfer a spin current generated from the SOT generation layer to the free layer.

## Description

### FIELD OF THE INVENTION

Some example embodiments of the disclosure relate to magnetic memory devices including a tunneling magnetoresistance layer, methods of manufacturing the magnetic memory device, and/or memory apparatuses including the magnetic memory device.

### BACKGROUND OF THE INVENTION

A magnetic memory apparatus such as magnetic random-access memory (MRAM) stores data by using a change in the resistance of a magnetic tunneling junction device. The resistance of the magnetic tunneling junction device varies with the magnetization direction of a free layer. For example, when the magnetization direction of the free layer is the same as the magnetization direction of a pinned layer, the magnetic tunneling junction device may have a relatively low resistance, and when these magnetization directions are opposite to each other, the magnetic tunneling junction device may have a relatively high resistance. When this characteristic is used in a memory apparatus, for example, a magnetic tunneling junction device may represent data '0' when having a relatively low resistance and the magnetic tunneling junction device may represent data '1' when having a relatively high resistance.

Such a magnetic memory apparatus has advantages of non-volatility, relatively high-speed operation, and/or relatively high durability. For example, spin transfer torque-magnetic RAM (STT-MRAM) that is currently mass-produced may have an operating speed of about 50 nsec to 100 nsec and also may have improved data retention greater than or equal to 10 years. In addition, spin-orbit torque (SOT)-MRAM may have a relatively very high operation speed less than or equal to 5 nsec, which is faster than the STT-MRAM because a spin polarization direction is perpendicular to the magnetization direction. Moreover, the SOT-MRAM may have more stable characteristics because a path of a write current and a path of a read current are different from each other.

### SUMMARY OF THE INVENTION

Some example embodiments of the present disclosure provide magnetic memory devices including a tunneling magnetoresistance layer and a memory apparatus including the magnetic memory device.

Some example embodiments of the present disclosure provide methods of manufacturing a magnetic memory device including a tunneling magnetoresistance layer.

Additional aspects will be set forth in part in the description which follows and, in part, will be apparent from the description, or may be learned by practice of the presented example embodiments of the disclosure.

Embodiments may, for example, provide a top SOT-MRAM structure using Orbital Hall Effect. By using OHE, lower current density can be obtained; the process difficulty of the integration scheme can be alleviated with a bottom PL structure; and a field-free switching can be achieved, so that the structure may be capable of solving various challenges of the conventional SOT-MRAM simultaneously.

There may be provided a semiconductor chip adopting SOT-MRAM as embedded memory or standalone memory.

By way of example, there may be provided a 3-terminal SOT-MRAM device structure, comprising:
an OHE layer, which is disposed on an upper portion of an MTJ and is composed of one or more materials selected from the group consisting of Ir, IrMn, PtMn, V, Cr, Mn, Nb, Mo, Ru, Ta, W, and Re, each having Orbital Hall Effect with high spin current generation efficiency; and
a converter layer, which is composed of Pt and disposed between the material having the Orbital Hall Effect and a free layer material.The structure may comprise a sub-oxide layer composed of various metal oxides including MgO, TaOx, HfOx, ZrOz, MgAlOx, and WOx is positioned between the Pt converter material layer and the free layer, and the sub-oxide layer may have a thickness in a range of 0.5 to 3 nm.

According to some embodiments, there may be provided a pinned layer structure, wherein a synthetic antiferromagnet material is formed below a tunnel barrier, and wherein a thickness ratio between a PL1 and a PL2 of synthetic antiferromagnet material is configured such that either PL1 > PL2 or PL2 > PL1, to form a stray field in a free layer.

According to an example embodiment, a method of manufacturing a magnetic memory device includes sequentially forming a pinned layer material, a tunnel barrier layer material, a free layer material, and a spin current transfer layer material on an electrode material, forming a mask layer on the spin current transfer layer material, forming a first electrode, a pinned layer, a tunnel barrier layer, a free layer, and a spin current transfer layer by removing the spin current transfer layer material, the free layer material, the tunnel barrier layer material, the pinned layer material, and the electrode material which are exposed by the mask layer through a first etching process, forming an insulating layer to surround side surfaces of the first electrode, the pinned layer, the tunnel barrier layer, the free layer, and the spin current transfer layer and cover a side surface and an upper surface of the mask layer, performing a second etching process until an upper surface of the spin current transfer layer is exposed, and forming a spin-orbit torque (SOT) generation layer in contact with the upper surface of the spin current transfer layer.

The method may further include forming a second electrode and a third electrode on the upper surface of the SOT generation layer, the second electrode and the third electrode being spaced apart from each other.

The SOT generation layer may include at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof.

The spin current transfer layer may include platinum (Pt).

The first etching process may be performed through ion beam etching (IOE).

The second etching process may include planarizing an upper surface of the insulating layer until the mask layer is exposed, and removing the mask layer through reactive ion etching (RIE), and additionally planarizing the insulating layer.

According to an example embodiment, a magnetic memory device includes a spin-orbit torque (SOT) generation layer configured to generate a SOT, a spin current transfer layer on a lower surface of the SOT generation layer, and a tunneling magnetoresistance layer on a lower surface of the spin current transfer layer and including a free layer, a tunnel barrier layer, and a pinned layer, wherein the spin current transfer layer is configured to transfer a spin current generated from the SOT generation layer to the free layer, the SOT generation layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof, and the spin current transfer layer includes platinum (Pt).

The SOT generation layer may include an orbital Hall conductance layer configured to provide an orbital Hall current due to an orbital Hall effect (OHE), and the orbital Hall conductance layer may include at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), or an alloy thereof.

The orbital Hall conductance layer may include a first orbital Hall conductance layer on the spin current transfer layer and a second orbital Hall conductance layer on the first orbital Hall conductance layer, and the first orbital Hall conductance layer and the second orbital Hall conductance layer each include at least one material different from each other among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), or alloys thereof.

The SOT generation layer may include a spin Hall conductance layer configured to provide a spin Hall current due to a spin Hall effect (SHE), and the spin Hall conductance layer may include platinum (Pt) or tungsten (W) having a beta (β) phase.

A thickness of the spin current transfer layer may be about 0.1 nm or more and about 10 nm or less.

The SOT generation layer may include an orbital Hall conductance layer on the spin current transfer layer and configured to provide an orbital Hall current due to an OHE, and a spin Hall conductance layer on the orbital Hall conductance layer and configured to provide a spin Hall current by a SHE.

The SOT generation layer may include a spin Hall conductance layer on the spin current transfer layer and configured to provide a spin Hall current due to a SHE, and an orbital Hall conductance layer on the spin Hall conductance layer and configured to provide an orbital Hall current by an OHE.

The magnetic memory device may further include an oxide layer between the free layer and the spin current transfer layer, and the oxide layer may include at least one of magnesium oxide (MgO), tantalum oxide (TaO), magnesium aluminum oxide (MgAlOₓ), aluminum oxide (AlOₓ), hafnium oxide (HfOₓ), zirconium oxide (ZrOₓ), magnesium tantalum oxide (MgTaOₓ), titanium oxide (TiOₓ), or tungsten oxide (WOₓ).

The magnetic memory device may further include a diffusion barrier metal layer between the free layer and the spin current transfer layer, and the diffusion barrier metal layer may have a single layer or multilayer structure including at least one metal of tantalum (Ta), tungsten (W), iridium (Ir), titanium (Ti), rhenium (Re), cobalt (Co), or an alloy thereof.

The pinned layer may include a first ferromagnetic layer, a second ferromagnetic layer, and an antiferromagnetic coupling layer between the first ferromagnetic layer and the second ferromagnetic layer, and a magnetization direction of the first ferromagnetic layer may be opposite to a magnetization direction of the second ferromagnetic layer.

The magnetic memory device may further include a first electrode electrically connected to the pinned layer, and a second electrode and a third electrode spaced apart from each other on the SOT generation layer.

A plurality of tunneling magnetoresistance layers and a plurality of spin current transfer layers may correspond to one SOT generation layer.

The SOT generation layer may include at least one material among platinum (Pt), iridium (Ir), ruthenium (Ru), or titanium (Ti).

The magnetic memory device may further include a plurality of first electrodes electrically connected to corresponding pinned layers, respectively, among a plurality of pinned layers of the plurality of tunneling magnetoresistance layers, and a second electrode and a third electrode spaced apart from each other on the SOT generation layer.

According to an example embodiment, a memory apparatus includes a plurality of memory cells each including a magnetic memory device and a switching device connected to the magnetic memory device, the magnetic memory device includes a SOT generation layer configured to generate a SOT, a spin current transfer layer on a lower surface of the SOT generation layer, and a tunneling magnetoresistance layer on a lower surface of the spin current transfer layer and including a free layer, a tunnel barrier layer, and a pinned layer, the spin current transfer layer is configured to transfer a spin current generated from the SOT generation layer to the free layer, the SOT generation layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof, and the spin current transfer layer includes platinum (Pt).

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a schematic configuration of a magnetic memory device according to an example embodiment;
FIG. 2 is a cross-sectional view illustrating a wiring structure disposed in a lower portion of the magnetic memory device shown in FIG. 1;
FIG. 3 is a cross-sectional view illustrating a schematic configuration of a magnetic memory device according to another example embodiment;
FIGS. 4A to 4I are cross-sectional views schematically illustrating a method of manufacturing the magnetic memory device shown in FIG. 1;
FIG. 5 is a cross-sectional view illustrating a schematic configuration of a magnetic memory device according to another example embodiment;
FIG.6 is a cross-sectional view illustrating a schematic configuration of a magnetic memory device according to another example embodiment;
FIG. 7 is a cross-sectional view illustrating a schematic configuration of a magnetic memory device according to another example embodiment;
FIG. 8 is a cross-sectional view illustrating a schematic configuration of a magnetic memory device according to another example embodiment;
FIG. 9 is a cross-sectional view illustrating a schematic configuration of a magnetic memory device according to another example embodiment;
FIG. 10 is a cross-sectional view illustrating a schematic configuration of a magnetic memory device according to another example embodiment;
FIG. 11 is a cross-sectional view illustrating a schematic configuration of a magnetic memory device according to another example embodiment;
FIG. 12 schematically shows one magnetic memory cell including a magnetic memory device according to an example embodiment;
FIG. 13 is a circuit diagram schematically illustrating a configuration of a memory apparatus including a plurality of memory cells shown in FIG. 12;
FIG. 14 is a cross-sectional view schematically illustrating a configuration of a memory apparatus according to another example embodiment; and
FIG. 15 is a conceptual diagram schematically illustrating a device architecture applicable to an electronic device.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the present example embodiments are merely described below, by referring to the figures, to explain aspects. As used herein, the term "and/or" includes any and all combinations of one or more of the associated listed items. As used herein, expressions such as "one of," "one or more of," "any one of," "at least one of," "at least one among" and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same" is used in description of example embodiments, it should be understood that some imprecisions may exist. Thus, when one element is referred to as being the same as another element, it should be understood that the one element is the same as another element within a desired manufacturing tolerance range (e.g., ±10%).

When the terms "about" or "substantially" are used in this specification in connection with a numerical value, it is intended that the associated numerical value includes a manufacturing tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, with reference to the accompanying drawings, a magnetic memory device, a method of manufacturing the magnetic memory device, and a memory apparatus including the magnetic memory device will be described in detail. Like reference numerals refer to like elements throughout, and in the drawings, sizes of elements may be exaggerated for clarity and convenience of explanation. The example embodiments described below are merely examples, and various modifications may be possible from the example embodiments.

In a layer structure described below, an expression "on/below" may include not only "immediately on/below in a contact manner" but also "on/below in a noncontact manner". An expression used in the singular encompasses the expression of the plural, unless it has a clearly different meaning in the context. It will be further understood that the terms "comprises" and/or "comprising" used herein specify the presence of stated features or elements, but do not preclude the presence or addition of one or more other features or elements.

The use of "the" and other demonstratives similar thereto may correspond to both a singular form and a plural form. Unless the order of operations of a method according to the disclosure is explicitly mentioned or described otherwise, the operations may be performed in a proper order. The disclosure is not limited to the order the operations are mentioned.

The term used in the example embodiments such as "unit" or "module" indicates a unit for processing at least one function or operation, and may be implemented in hardware or software, or in a combination of hardware and software.

The connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language provided herein, is intended merely to better illuminate the disclosure and does not pose a limitation on the scope of the disclosure unless otherwise claimed.

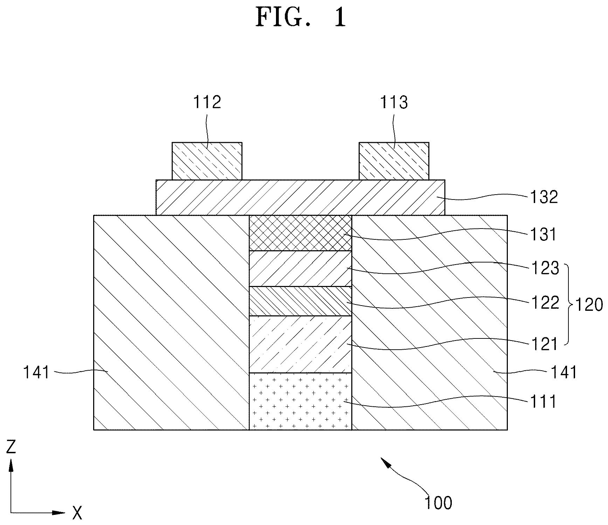

FIG. 1 is a cross-sectional view illustrating a schematic configuration of a magnetic memory device 100 according to an example embodiment. Referring to FIG. 1, the magnetic memory device 100 according to an example embodiment may include a tunneling magnetoresistance layer 120, a spin current transfer layer 131, and an orbital Hall conductance layer 132 disposed on the spin current transfer layer 131. The tunneling magnetoresistance layer 120 and the orbital Hall conductance layer 132 may face each other, and the spin current transfer layer 131 may be provided between the tunneling magnetoresistance layer 120 and the orbital Hall conductance layer 132.

The tunneling magnetoresistance layer 120 may include a pinned layer 121, a tunnel barrier layer 122 provided on the pinned layer 121, and a free layer 123 provided on the tunnel barrier layer 122. The pinned layer 121 and the free layer 123 may face each other, and the tunnel barrier layer 122 may be provided between the pinned layer 121 and the free layer 123. The spin current transfer layer 131 may be provided on the free layer 123. The orbital Hall conductance layer 132 may be provided to face the free layer 123, and the spin current transfer layer 131 may be provided between the orbital Hall conductance layer 132 and the free layer 123.

When the configuration of the magnetic memory device 100 is described from the top, the magnetic memory device 100 may include the orbital Hall conductance layer 132, the spin current transfer layer 131 provided on a lower surface of the orbital Hall conductance layer 132, and the tunneling magnetoresistance layer 120 provided on a lower surface of the spin current transfer layer 131. The tunneling magnetoresistance layer 120 may be provided to face the lower surface of the orbital Hall conductance layer 132 at a lower portion of the orbital Hall conductance layer 132. The spin current transfer layer 131 may be provided between the lower surface of the orbital Hall conductance layer 132 and an upper surface of the tunneling magnetoresistance layer 120. The tunneling magnetoresistance layer 120 may include the free layer 123, the tunnel barrier layer 122, and the pinned layer 121 in order from the top to the bottom. The free layer 123 may be provided to face the lower surface of the orbital Hall conductance layer 132 at the lower portion of the orbital Hall conductance layer 132. The spin current transfer layer 131 may be provided between the lower surface of the orbital Hall conductance layer 132 and an upper surface of the free layer 123. The free layer 123 may be in contact with a lower surface of the spin current transfer layer 131.

The pinned layer 121 and the free layer 123 may each include a ferromagnetic metal material having magnetism. For example, the pinned layer 121 and the free layer 123 may each include at least one ferromagnetic material among iron (Fe), cobalt (Co), nickel (Ni), manganese (Mn), a Fe-containing alloy, a Co-containing alloy, a Ni-containing alloy, a Mn-containing alloy, or a Heusler alloy. The pinned layer 121 and the free layer 123 may include the same ferromagnetic material, but example embodiments are not limited thereto. In addition, the free layer 123 may further include boron (B) to improve wetting characteristics of the free layer 123 in a process of depositing the free layer 123 on the tunnel barrier layer 122. For example, the free layer 123 may include CoFeB.

In addition, the pinned layer 121 and the free layer 123 may each be configured to have a high perpendicular magnetic anisotropy (PMA). In other words, PMA energy of each of the pinned layer 121 and the free layer 123 may exceed out-of-plane magnetization energy. In this case, a magnetic moment of each of the pinned layer 121 and the free layer 123 may be stabilized in a thickness direction (e.g., a Z direction) or in a direction perpendicular to a horizontal direction or a plane direction (e.g., an X direction).

The pinned layer 121 may have a pinned magnetization direction. Once determined, the magnetization direction of the pinned layer 121 may not be changed. On the other hand, the free layer 123 may have a variable magnetization direction. The tunneling magnetoresistance layer 120 may have a relatively low resistance when the magnetization directions of the pinned layer 121 and the free layer 123 are the same, and may have a relatively high resistance when the magnetization directions of the pinned layer 121 and the free layer 123 are opposite. This phenomenon is called tunneling magnetoresistance (TMR).

The free layer 123 may have a relatively low saturation magnetization (Ms) such that the magnetization direction may be easily changed. To this end, the free layer 123 may be doped with at least one non-magnetic metal among, for example, Mg, Ru, Ir, Ti, Zn, Ga, Ta, Al, Mo, Zr, Sn, W, Sb, V, Nb, Cr, Ge, Si, Hf, Tb, Sc, Y, Rh, In, Ca, Sr, Ba, Be, V, Li, Cd, Pb, or Ga. A doping concentration of the non-magnetic metal in the free layer 123 may be in a range of, for example, about 5 at% to about 50 at%.

The tunnel barrier layer 122 may serve as a tunnel barrier for a magnetic tunneling junction. The tunnel barrier layer 122 may include crystalline Mg oxide. For example, the tunnel barrier layer 122 may include MgO, MgAl₂O₄, or MgTiOₓ. The range of 'x' in MgTiOₓ may be not fixed to a specific single range, and various compounds may be formed depending on the range of 'x'.

The magnetization direction of the free layer 123 may be changed by a spin-orbit torque (SOT) generated due to a spin current generated in a vertical direction (e.g., Z direction) when current is applied to the orbital Hall conductance layer 132 in a horizontal direction (e.g., X direction). In this regard, the magnetic memory device 100 may be applied to a SOT magnetic random access memory (MRAM). The orbital Hall conductance layer 132 may be referred to as a "SOT generation layer". The orbital Hall conductance layer 132 may switch the magnetization direction of the free layer 123 by providing the spin current to the tunneling magnetoresistance layer 120 (more specifically, the free layer 123), according to the current flowing through the orbital Hall conductance layer 132. For example, the free layer 123 may be magnetized in a +Z direction or a -Z direction according to a direction of the current applied to the orbital Hall conductance layer 132.

According to an example embodiment, the orbital Hall conductance layer 132 may include an element or an alloy thereof having a relatively high orbital Hall conductance (OHC) obtained by an orbital Hall effect (OHE). For example, the orbital Hall conductance layer 132 may include at least one material among iridium (Ir), manganese (Mn), vanadium (V), chromium (Cr), niobium (Nb), molybdenum (Mo), ruthenium (Ru), tantalum (Ta), tungsten (W), rhenium (Re), or an alloy thereof. For example, the alloy may include IrMn or PtMn. A thickness of the orbital Hall conductance layer 132 may be, for example, about 1 nm or more to about 10 nm or less, or about 3 nm or more to about 7 nm or less, or about 4 nm or more to about 6 nm or less.

According to an example embodiment, an orbital Hall current may be generated in the orbital Hall conductance layer 132 when current is applied to the orbital Hall conductance layer 132 having a relatively large OHC. The orbital Hall current may be converted into a spin Hall current by the spin current transfer layer 131. In this regard, the spin current transfer layer 131 may serve as a conversion layer converting the orbital Hall current into the spin Hall current. In addition, because current flows in the spin current transfer layer 131, the spin Hall current may be also generated by a spin Hall effect (SHE) in the spin current transfer layer 131 itself. Thus, the spin current transfer layer 131 may transfer the spin current generated by the OHE and the spin current generated by the SHE to the free layer 123. Therefore, a relatively large spin current may be generated by the orbital Hall conductance layer 132 and the spin current transfer layer 131 acting together. Then, even though the current applied to the orbital Hall conductance layer 132 is relatively small, the spin current sufficient to perform magnetic switching on the free layer 123 of the tunneling magnetoresistance layer 120 may be obtained, and accordingly, the magnetic memory device 100 may have a relatively low operating current density.

The spin current transfer layer 131 may include a material capable of converting the orbital Hall current into a spin current and generating the spin current by itself due to the SHE. In addition, the spin current transfer layer 131 may include a material with a relatively high selectivity in a reactive ion etching (RIE) process described below. For example, the spin current transfer layer 131 may include platinum (Pt). The thickness of the spin current transfer layer 131 may be about 0.1 nm or more and about 10 nm or less, about 0.1 nm or more and about 5 nm or less, about 0.5 nm or more and about 5 nm or less, about 0.5 nm or more and about 4 nm or less, or about 1 nm or more and about 3 nm or less.

The magnetic memory device 100 may further include a first electrode 111 for reading the resistance of the tunneling magnetoresistance layer 120, a second electrode 112 and a third electrode 113 for applying current to the orbital Hall conductance layer 132. The first electrode 111 may be electrically connected to the pinned layer 121. The second electrode 112 and the third electrode 113 may be provided to be spaced apart from each other on the upper surface of the orbital Hall conductance layer 132. When voltage is applied to each of the second electrode 112 and the third electrode 113, an orbital Hall current may be generated while current flows through the orbital Hall conductance layer 132.

In addition, the magnetic memory device 100 may further include an insulating layer 141 surrounding side surfaces of the first electrode 111, the tunneling magnetoresistance layer 120, and the spin current transfer layer 131. A memory apparatus such as a SOT MRAM may include a plurality of magnetic memory devices 100 two-dimensionally arranged, and the plurality of magnetic memory devices 100 may be electrically separated from each other by the insulating layer 141. The orbital Hall conductance layer 132 may be provided on an upper surface of the insulating layer 141 to be in contact with the upper surface of the spin current transfer layer 131.

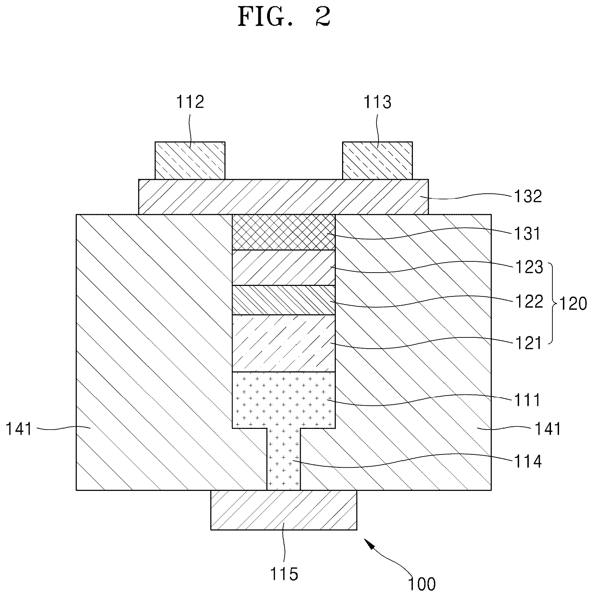

FIG. 2 is a cross-sectional view illustrating a wiring structure disposed in a lower portion of the magnetic memory device 100 shown in FIG. 1. When the magnetic memory device 100 is used in a memory apparatus such as a SOT MRAM, various circuits such as an output circuit and a control circuit, and wirings electrically connecting the magnetic memory device 100 to the circuits may be provided in the lower portion of the magnetic memory device 100. Referring to FIG. 2, the magnetic memory device 100 may further include a wiring 115 provided in a lower portion of the first electrode 111 and a via layer 114 electrically connecting the first electrode 111 to the wiring 115 between the first electrode 111 and the wiring 115. The insulating layer 141 may further extend downward so as to surround a side surface of the via layer 114. The wiring 115 may be provided on a lower surface of the insulating layer 141.

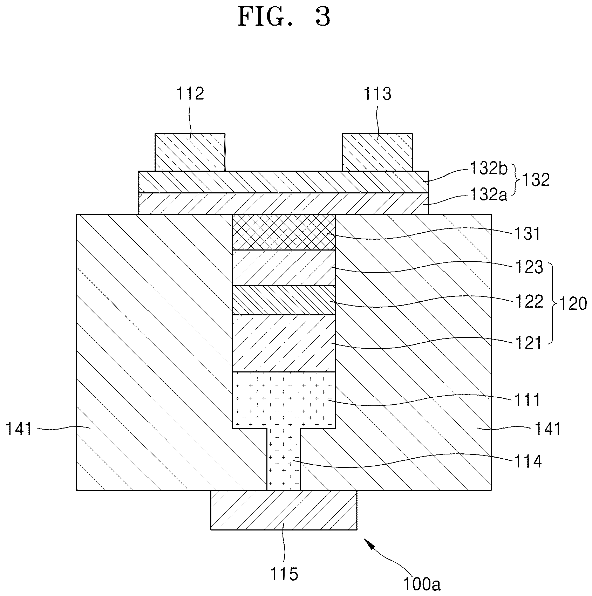

FIG. 3 is a cross-sectional view illustrating a schematic configuration of a magnetic memory device 100a according to another example embodiment. FIGS. 1 and 2 show that the orbital Hall conductance layer 132 has a single layer structure, but example embodiments are not limited thereto, and the orbital Hall conductance layer 132 may have a multilayer structure in which different materials are stacked. Referring to FIG. 3, the orbital Hall conductance layer 132 of the magnetic memory device 100a may include a first orbital Hall conductance layer 132a and a second orbital Hall conductance layer 132b disposed on the first orbital Hall conductance layer 132a. The first orbital Hall conductance layer 132a may be provided on the spin current transfer layer 131. In other words, the first orbital Hall conductance layer 132a may be provided between the spin current transfer layer 131 and the second orbital Hall conductance layer 132b. The second electrode 112 and the third electrode 113 may be provided to be spaced apart from each other on an upper surface of the second orbital Hall conductance layer 132b. The first orbital Hall conductance layer 132a and the second orbital Hall conductance layer 132b may include one or more materials different from each other among, for example, iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), and alloys thereof. For example, the first orbital Hall conductance layer 132a may include iridium (Ir), and the second orbital Hall conductance layer 132b may include manganese (Mn), or, the first orbital Hall conductance layer 132a may include manganese (Mn), and the second orbital Hall conductance layer 132b may include iridium (Ir).

As described above, because the magnetic memory devices 100 and 100a according to the above example embodiments perform magnetic switching of the free layer 123 by using a SOT, the magnetic memory devices 100 and 100a may have a faster operation speed than the magnetic memory device using a spin-transfer torque (STT). For example, the magnetic memory devices 100 and 100a according to the above example embodiments may have a relatively fast operation speed of about 5 nsec or less or about 1 nsec or less. In addition, the magnetic memory devices 100 and 100a according to the above example embodiments may operate at a relatively low current density while having a relatively high operating speed, and thus may have a relatively low power consumption.

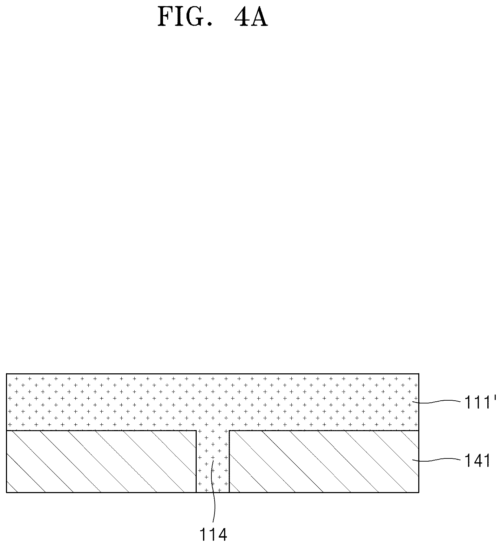

FIGS. 4A to 4I are cross-sectional views schematically illustrating a method of manufacturing the magnetic memory device 100 shown in FIG. 1.

Referring to FIG. 4A, an electrode material 111' may be formed first. When the magnetic memory device 100 is formed on a circuit layer of a memory apparatus such as a SOT-MRAM, the insulating layer 141 may be formed on the circuit layer first. In addition, after forming a via hole by etching a portion of the insulating layer 141, the via layer 114 may be formed by filling the via hole with a conductive material. Then, an electrode material 111' having conductivity may be deposited on the insulating layer 141. However, example embodiments are not necessarily limited thereto, and it is also possible to deposit the electrode material 111' on other substrates according to an application. The electrode material 111' may include, for example, TiN or TaN.

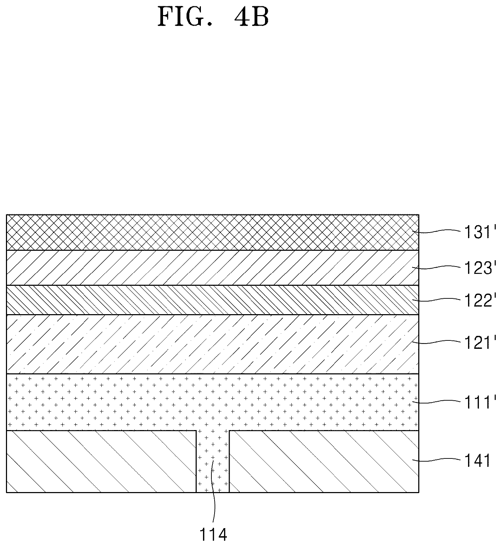

Referring to FIG. 4B, a pinned layer material 121', a tunnel barrier layer material 122', a free layer material 123', and a spin current transfer layer material 131' may be sequentially formed on the electrode material 111'. Although not shown in FIG. 4B, after a seed layer is first formed on the electrode material 111', the pinned layer material 121' may be formed on the seed layer. The crystal of a ferromagnetic metal material used in the pinned layer 121 mainly has a hexagonal close-packed (HCP) structure with a crystal direction (0001). The seed layer may improve crystallinity of the pinned layer material 121', and accordingly may improve the PMA of the pinned layer 121. In addition, in a structure according to an example embodiment in which the pinned layer 121 is located below the tunnel barrier layer 122, the pinned layer material 121' is not formed on the tunnel barrier material 122', and thus, the PMA of the pinned layer 121 may be further improved compared to a structure in which the pinned layer 121 is located on the tunnel barrier layer 122.

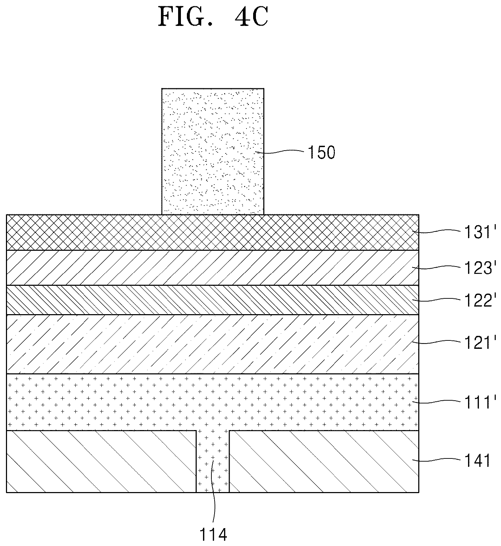

Referring to FIG. 4C, a mask layer 150 may be formed on an upper surface of the spin current transfer layer material 131'. The mask layer 150 may be partially formed on a region to be left without being etched in a subsequent etching process.

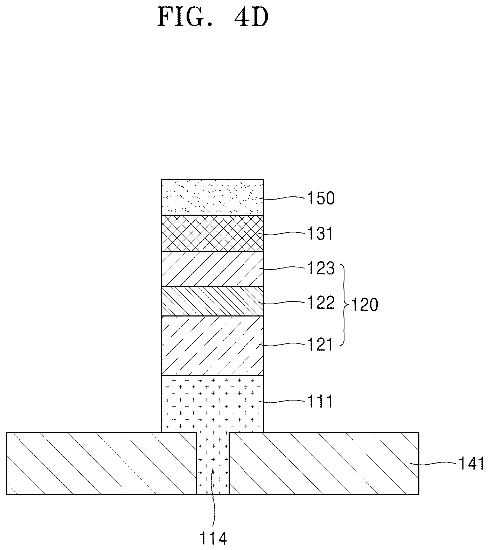

Referring to FIG. 4D, the spin current transfer layer material 131', the free layer material 123', the tunnel barrier layer material 122', the pinned layer material 121', and the electrode material 111' in the remaining region not covered with (e.g., exposed by) the mask layer 150 may be sequentially removed through an etching process, except for a region covered with the mask layer 150. The etching process may be performed through, for example, ion beam etching (IOE). Accordingly, the first electrode 111, the pinned layer 121, the tunnel barrier layer 122, the free layer 123, and the spin current transfer layer 131 may be formed. Also, the tunneling magnetoresistance layer 120 including the pinned layer 121, the tunnel barrier layer 122, and the free layer 123 may be formed. According to an example embodiment, the free layer 123 may be protected by the spin current transfer layer 131 disposed thereon, thereby reducing or preventing the surface of the free layer 123 from being damaged by an ion beam during the etching process. Accordingly, the PMA of the free layer 123 may be improved.

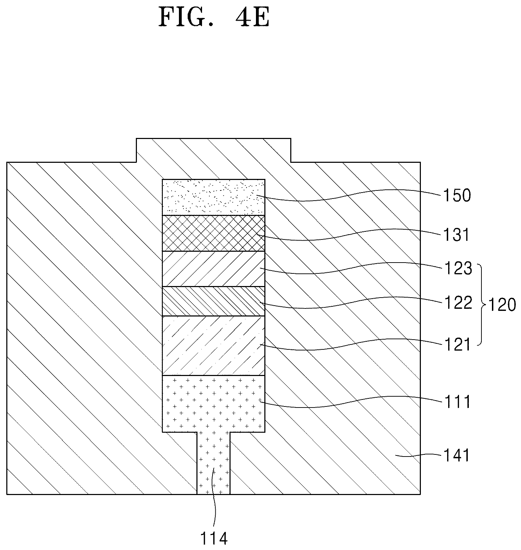

Referring to FIG. 4E, the region removed through the etching process may be filled with the insulating layer 141. The insulating layer 141 may be formed to cover an upper surface of the mask layer 150. Then, the insulating layer 141 may completely surround side surfaces of the first electrode 111, the pinned layer 121, the tunnel barrier layer 122, the free layer 123, and the spin current transfer layer 131. In addition, the insulating layer 141 may cover a side surface and the upper surface of the mask layer 150.

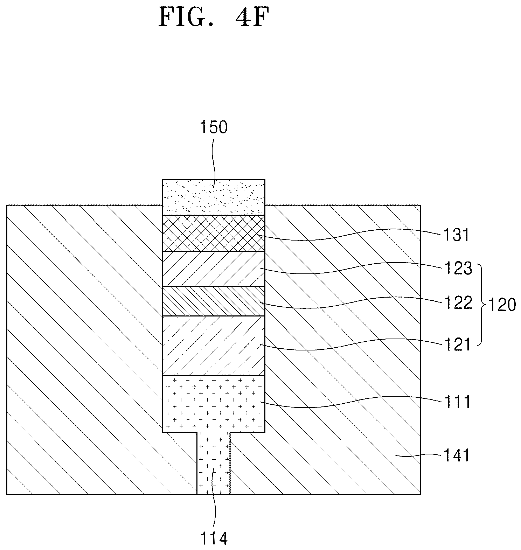

Referring to FIG. 4F, an upper surface of the insulating layer 141 may be planarized through a planarization process such as chemical mechanical plating (CMP). This planarization process may be performed until the mask layer 150 is exposed. In the planarization process, the mask layer 150 may protrude upward from the insulating layer 141 without being removed.

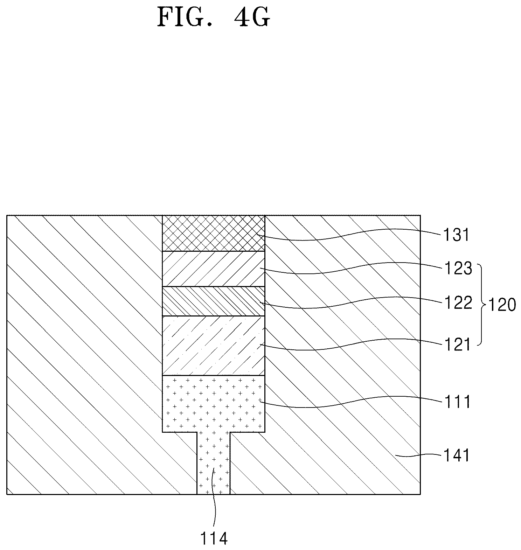

Referring to FIG. 4G, the mask layer 150 may be removed through the etching process, and the insulating layer 141 may be additionally planarized. The etching process may be performed through, for example, RIE. The etching process may be performed until an upper surface of the spin current transfer layer 131 is exposed. The spin current transfer layer 131 may function as an etching stop layer in the etching process. Because platinum (Pt), which is a material of the spin current transfer layer 131, has a relatively high selectivity of, for example, 5 or more with respect to an etching gas such as XeF, the spin current transfer layer 131 may be used as the etching stop layer. In addition, the spin current transfer layer 131 may protect other layers while RIE is being performed. In the additional planarization process shown in FIG. 4G, the upper portion of the spin current transfer layer 131 may be partially etched, and thus the thickness of the spin current transfer layer 131 may be slightly reduced. Therefore, in the deposition process shown in FIG. 4B, the spin current transfer layer material 131' may be deposited slightly thicker than a target thickness of the final spin current transfer layer 131.

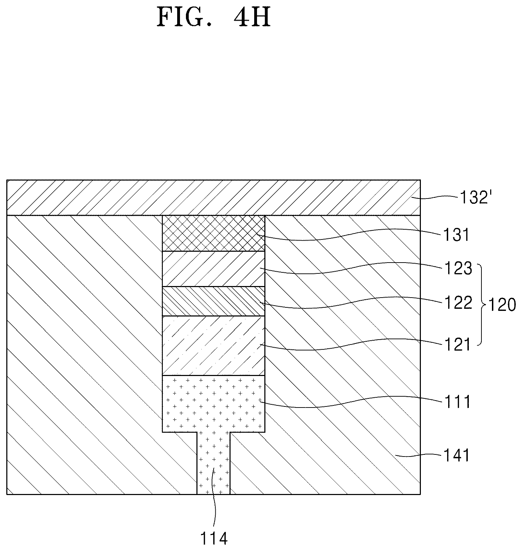

Referring to FIG. **4H****,** an orbital Hall conductance layer material 132' may be formed to cover the entire upper surface of the insulating layer 141. Then, the orbital Hall conductance layer material 132' may also cover the upper surface of the spin current transfer layer 131.

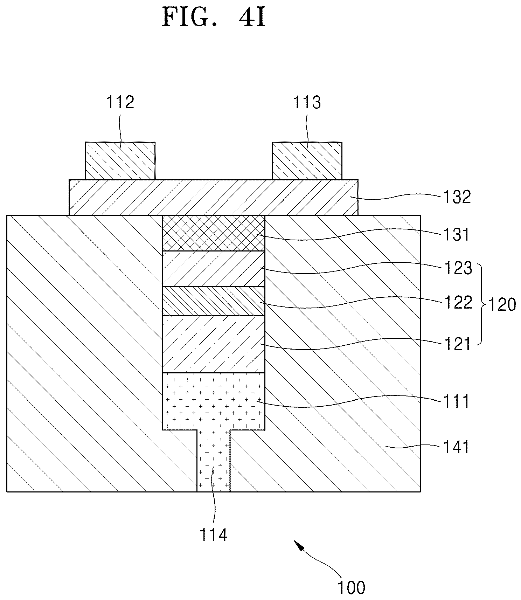

Referring to FIG. 4I, the remaining portion of the orbital Hall conductance layer material 132' may be removed through etching while leaving a portion of the orbital Hall conductance layer material 132' contacting the upper surface of the spin current transfer layer 131 and a portion of the insulating layer 141 surrounding the spin current transfer layer 131. Accordingly, the orbital Hall conductance layer 132 contacting the upper surface of the spin current transfer layer 131 may be formed. The width of the orbital Hall conductance layer 132 may be greater than the width of the spin current transfer layer 131. Then, a portion of the orbital Hall conductance layer 132 may further extend upward the upper surface of the insulating layer 141. Thereafter, the second electrode 112 and the third electrode 113 which are spaced apart from each other may be formed on the upper surface of the orbital Hall conductance layer 132. Then, the magnetic memory device 100 may be completed.

After the additional planarization process shown in FIG. 4G, the spin current transfer layer 131 may be exposed to the outside until the orbital Hall conductance layer material 132' shown in FIG. 4H is formed. Because platinum (Pt), which is a material of the spin current transfer layer 131, has a relatively high resistance to oxidation, the surface of the spin current transfer layer 131 may be hardly oxidized until the orbital Hall conductance layer material 132' is formed. Therefore, in the manufacturing method according to the example embodiment, oxide is hardly formed at an interface between the spin current transfer layer 131 and the orbital Hall conductance layer 132, and thus, the characteristics of the magnetic memory device 100 may be further improved.

FIGS. 4A to 4I shows only one mask layer 150 for convenience, and one magnetic memory device 100 for convenience. However, a plurality of mask layers 150 two-dimensionally arranged may be formed on the spin current transfer layer material 131'. In this case, a plurality of magnetic memory devices 100 two-dimensionally arranged may be simultaneously formed. For example, a plurality of first electrodes 111, a plurality of pinned layers 121, a plurality of tunnel barrier layers 122, a plurality of free layers 123, and a plurality of spin current transfer layers 131 which are separated from each other may be formed simultaneously in the etching process shown in FIG. 4D. In the etching process shown in FIG. 4D, the insulating layer 141 or another substrate disposed in the lower portion of the first electrode 111 may be an etching stop layer. Accordingly, in the etching process shown in FIG. 4D, etching may be performed to a sufficient depth, and thus yield of the magnetic memory device 100 may be improved. For example, some of the plurality of finally formed magnetic memory devices 100 may be reduced or prevented from being electrically connected to each other.

When the magnetic memory device 100 described above is used in a memory apparatus such as a SOT-RMAM or other electronic devices, additional wiring and circuits may be formed on the magnetic memory device 100 through a back-end-of-line (BEOL) process. According to the example embodiment, the pinned layer 121 is disposed in a lower portion of the magnetic memory device 100, and thus, heat transferred to the pinned layer 121 in the subsequent BEOL process may be reduced. Therefore, the risk of the pinned layer 121 being damaged due to high heat may be reduced in the subsequent BEOL process.

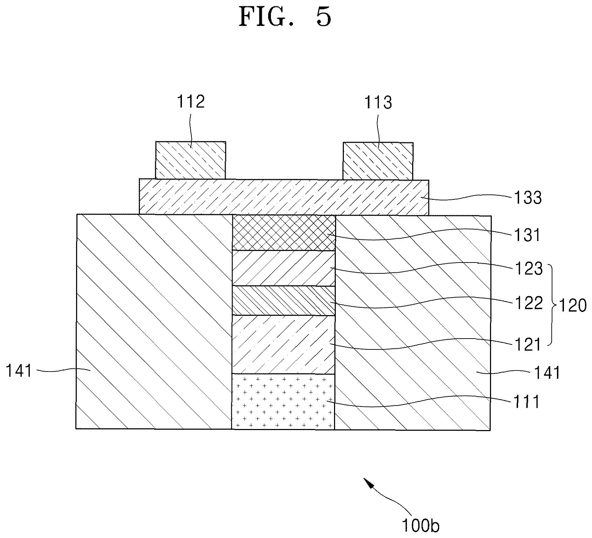

FIG. 5 is a cross-sectional view illustrating a schematic configuration of a magnetic memory device 100b according to another example embodiment. Referring to FIG. 5, the magnetic memory device 100b may include a spin Hall conductance layer 133 instead of the orbital Hall conductance layer 132 as a "SOT generation layer". The remaining configuration of the magnetic memory device 100b illustrated in FIG. 5 may be the same as the configuration of the magnetic memory device 100 illustrated in FIG. 1. The spin Hall conductance layer 133 may include an element or an alloy thereof having a relatively high spin Hall conductance (SHC) due to an SHE. For example, the spin Hall conductance layer 133 may include platinum (Pt) or tungsten (W) having a beta (β) phase (e.g., beta-tungsten (βW)). When current is applied to the spin Hall conductance layer 133 in a horizontal direction, a spin Hall current may be generated due to the SHE. The spin current transfer layer 131 may transfer the spin Hall current generated in the spin Hall conductance layer 133 to the free layer 123. A magnetization direction of the free layer 123 may be changed by the SOT generated due to the spin Hall current.

The magnetic memory device 100b illustrated in FIG. 5 may be manufactured using the same method as the method of manufacturing the magnetic memory device 100 illustrated in FIGS. 4A to 4I. For example, the magnetic memory device 100b may be manufactured by forming the spin Hall conductance layer 133 instead of the orbital Hall conductance layer 132 in the processes shown in FIGS. 4H and 4I. According to an example embodiment, the spin Hall conductance layer 133 is formed after an IOE process of forming the tunneling magnetoresistance layer 120 and an RIE process of removing the mask layer 150 and planarizing the insulating layer 141, and thus, there is little risk of a phase of the material of the spin Hall conductance layer 133 being changed in the etching process.

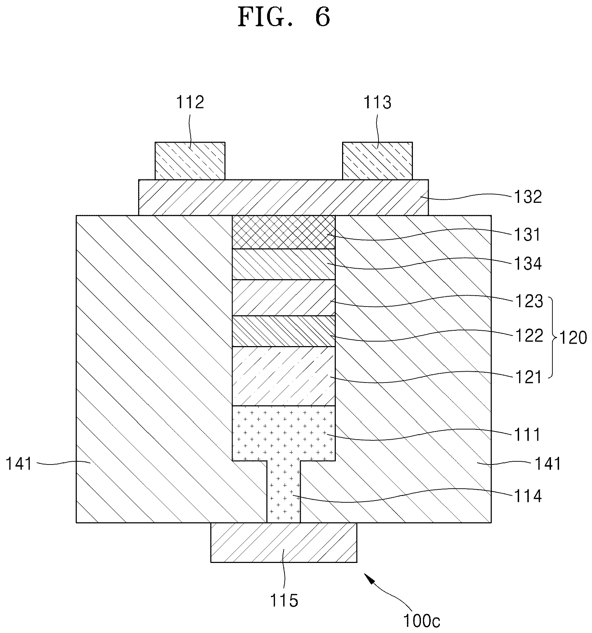

FIG.6 is a cross-sectional view illustrating a schematic configuration of a magnetic memory device 100c according to another example embodiment. Referring to FIG. 6, the magnetic memory device 100c may further include an oxide layer 134 disposed between the free layer 123 and the spin current transfer layer 131. When the free layer 123 and the spin current transfer layer 131 are in direct contact with each other, platinum (Pt) of the spin current transfer layer 131 is diffused into the free layer 123, which may deteriorate the PMA of the free layer 123 and reduce the tunneling magnetoresistance of the tunneling magnetoresistance layer 120. The oxide layer 134 may function as a diffusion prevention layer that prevents or reduces diffusion of the platinum (Pt) of the spin current transfer layer 131 into the free layer 123. The oxide layer 134 may include, for example, at least one material among magnesium oxide (MgO), tantalum oxide (TaO), magnesium aluminum oxide (MgAlOₓ), aluminum oxide (AlOₓ), hafnium oxide (HfOₓ), zirconium oxide (ZrOₓ), magnesium tantalum oxide (MgTaOₓ), titanium oxide (TiOₓ), or tungsten oxide (WOₓ).

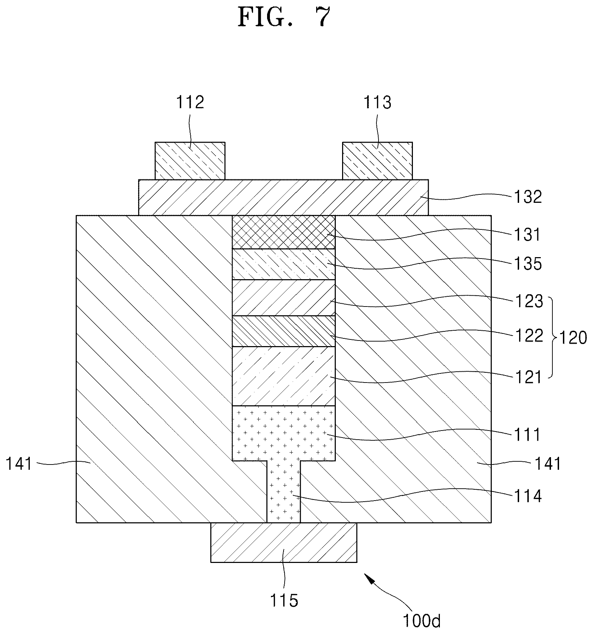

FIG. 7 is a cross-sectional view illustrating a schematic configuration of a magnetic memory device 100d according to another example embodiment. Referring to FIG. 7, the magnetic memory device 100d may further include a diffusion barrier metal layer 135 provided between the free layer 123 and the spin current transfer layer 131. The magnetic memory device 100d shown in FIG. 7 is different from the magnetic memory device 100c shown in FIG. 6 in that the magnetic memory device 100d includes the diffusion barrier metal layer 135 instead of the oxide layer 134. The diffusion barrier metal layer 135 may perform the same function as the oxide layer 134 in that the diffusion barrier metal layer 135 prevents or reduces the platinum (Pt) of the spin current transfer layer 131 from being diffused into the free layer 123, and is different from the oxide layer 134 in that the diffusion barrier metal layer 135 includes metal instead of oxide. In addition, the diffusion barrier metal layer 135 may have superior or better thermal stability compared to the oxide layer 134. Therefore, the diffusion barrier metal layer 135 may thermally protect the pinned layer 121 with little deformation in a subsequent BEOL process.

The diffusion barrier metal layer 135 may include at least one metal among, for example, tantalum (Ta), tungsten (W), iridium (Ir), titanium (Ti), rhenium (Re), cobalt (Co), or an alloy thereof. The diffusion barrier metal layer 135 may have a single layer structure or a multilayer structure. For example, the diffusion barrier metal layer 135 may have a multilayer structure of cobalt (Co)/iridium (Ir)/cobalt (Co). In addition to the multilayer structure of cobalt (Co)/iridium (Ir)/cobalt (Co), the diffusion barrier metal layer 135 may be formed in a multilayer structure of two or four or more layers each including any one metal of tantalum (Ta), tungsten (W), iridium (Ir), titanium (Ti), rhenium (Re), and cobalt (Co), or an alloy thereof.

The oxide layer 134 and the diffusion barrier metal layer 135 each may have a relatively thin thickness to transfer a spin current or a SOT to the free layer 123 without passing the platinum (Pt) therethrough. For example, the thickness of each of the oxide layer 134 and the diffusion barrier metal layer 135 may be selected within a range of about 0.5 nm or more and about 2 nm or less, about 0.5 nm or more and about 1 nm or less, or about 1 nm or more and about 2 nm or less according to the physical properties of an oxide material or a metal material actually used.

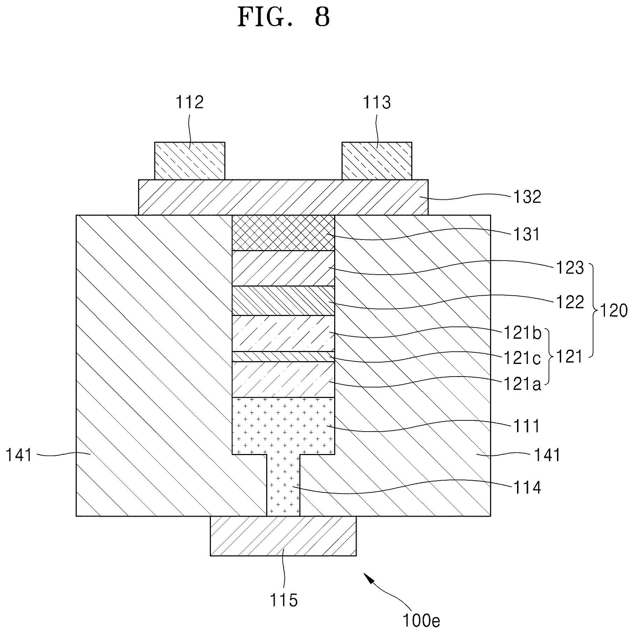

FIG. 8 is a cross-sectional view illustrating a schematic configuration of a magnetic memory device 100e according to another example embodiment. Referring to FIG. 8, the pinned layer 121 of the magnetic memory device 100e may have a synthetic antiferromagnet structure. For example, the pinned layer 121 may include a first ferromagnetic layer 121a, an antiferromagnetic coupling layer 121c provided on the first ferromagnetic layer 121a, and a second ferromagnetic layer 121b provided on the antiferromagnetic coupling layer 121c. In other words, the first ferromagnetic layer 121a and the second ferromagnetic layer 121b face each other, and the antiferromagnetic coupling layer 121c may be provided between the first ferromagnetic layer 121a and the second ferromagnetic layer 121b. The first ferromagnetic layer 121a may be provided on the first electrode 111, and the tunnel barrier layer 122 may be provided on the second ferromagnetic layer 121b.

The first ferromagnetic layer 121a and the second ferromagnetic layer 121b may each include a ferromagnetic metal material. The first ferromagnetic layer 121a and the second ferromagnetic layer 121b may each include at least one ferromagnetic material among, for example, iron (Fe), cobalt (Co), nickel (Ni), manganese (Mn), Fe-containing alloy, Co-containing alloy, Ni-containing alloy, Mn-containing alloy, or Heusler alloy. The first ferromagnetic layer 121a and the second ferromagnetic layer 121b may include the same ferromagnetic material, but example embodiments are not limited thereto.

The antiferromagnetic coupling layer 121c may include a non-magnetic metal that generates a Dzyaloshinskii-Moriya interaction at an interface between the first ferromagnetic layer 121a and the second ferromagnetic layer 121b. For example, the antiferromagnetic coupling layer 121c may include at least one of ruthenium (Ru), iridium (Ir), tantalum (Ta), tungsten (W), palladium (Pd), zirconium (Zr), platinum (Pt), aluminum (Al), or an alloy thereof. In this structure, the first ferromagnetic layer 121a and the second ferromagnetic layer 121b may form an antiferromagnet through the antiferromagnetic coupling layer 121c. In other words, the pinned layer 121 may have a stable state when a magnetization direction of the first ferromagnetic layer 121a and a magnetization direction of the second ferromagnetic layer 121b are opposite to each other.

According to the example embodiment, thicknesses of the first ferromagnetic layer 121a and the second ferromagnetic layer 121b may be different from each other so that a stray field may be applied to the free layer 123. For example, the thickness of the first ferromagnetic layer 121a may be greater than the thickness of the second ferromagnetic layer 121b or the thickness of the second ferromagnetic layer 121b may be greater than the thickness of the first ferromagnetic layer 121a such that the stray field may be generated in the free layer 123. Then, magnetic switching may be selectively performed on the free layer 123 without a configuration for applying a separate external magnetic field to the free layer 123.

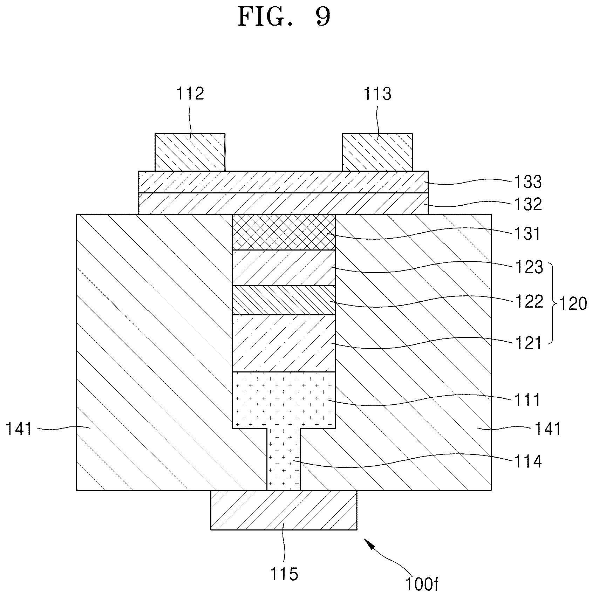

FIG. 9 is a cross-sectional view illustrating a schematic configuration of a magnetic memory device 100f according to another example embodiment. Referring to FIG. 9, the magnetic memory device 100f may include both the orbital Hall conductance layer 132 and the spin Hall conductance layer 133 as a "SOT generation layer". In other words, it may be seen that the magnetic memory device 100f includes a SOT generation layer, and the SOT generation layer includes the orbital Hall conductance layer 132 and the spin Hall conductance layer 133. The orbital Hall conductance layer 132 may be provided on the spin current transfer layer 131, and the spin Hall conductance layer 133 may be provided on the orbital Hall conductance layer 132. The second electrode 112 and the third electrode 113 may be provided to be spaced apart from each other on an upper surface of the spin Hall conductance layer 133.

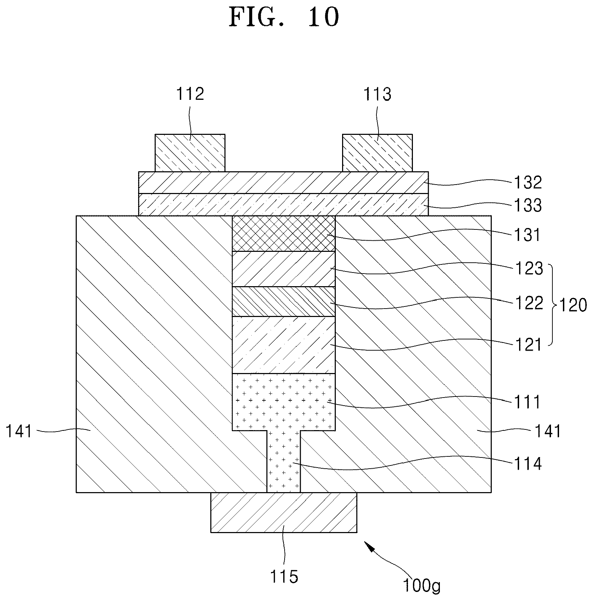

FIG. 10 is a cross-sectional view illustrating a schematic configuration of a magnetic memory device 100g according to another example embodiment. FIG. 9 illustrates that the spin Hall conductance layer 133 is provided on the orbital Hall conductance layer 132, but example embodiments are not limited thereto, and positions of the spin Hall conductance layer 133 and the orbital Hall conductance layer 132 may be exchanged with each other. Referring to FIG. 10, a SOT generation layer of the magnetic memory device 100g may include the spin Hall conductance layer 133 on the spin current transfer layer 131 and the orbital Hall conductance layer 132 on the spin Hall conductance layer 133. In this case, the second electrode 112 and the third electrode 113 may be provided to be spaced apart from each other on an upper surface of the orbital Hall conductance layer 132.

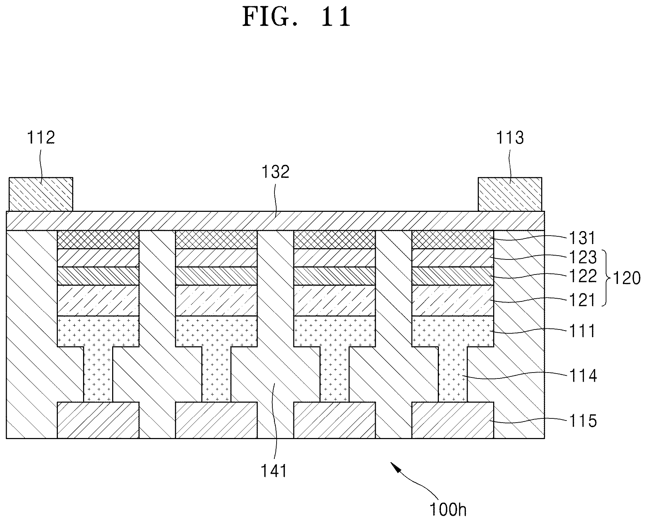

FIG. 11 is a cross-sectional view illustrating a schematic configuration of a magnetic memory device 100h according to another example embodiment. Referring to FIG. 11, the magnetic memory device 100h may include a plurality of tunneling magnetoresistance layers 120 connected to one orbital Hall conductance layer 132. For example, the magnetic memory device 100h may include a plurality of first electrodes 111, a plurality of tunneling magnetoresistance layers 120 provided on the plurality of first electrodes 111, respectively, a plurality of spin current transfer layers 131 provided on the plurality of tunneling magnetoresistance layers 120, respectively, a single orbital Hall conductance layer 132 provided on the plurality of spin current transfer layers 131, and the second electrode 112 and the third electrode 113 spaced apart from each other on an upper surface of the orbital Hall conductance layer 132. The plurality of first electrodes 111 may be electrically connected to the corresponding pinned layers among the plurality of pinned layers 121 of a plurality of tunneling magnetoresistance layers 120, respectively. In addition, the magnetic memory device 100h may further include a plurality of via layers 114 electrically connected to the plurality of first electrodes 111, respectively, and a plurality of wirings 115 electrically connected to the plurality of via layers 114, respectively. In addition, the magnetic memory device 100h may further include the insulating layer 141 provided between the plurality of tunneling magnetoresistance layers 120 to electrically separate the plurality of tunneling magnetoresistance layers 120 from each other.

Because the width of the orbital Hall conductance layer 132 and the distance between the second electrode 112 and the third electrode 113 in the magnetic memory device 100h shown in FIG. 11 are relatively long, the orbital Hall conductance layer 132 may include a material having a relatively high electrical conductivity or a material having a relatively low electrical resistance. For example, the orbital Hall conductance layer 132 may include at least one material among iridium (Ir), ruthenium (Ru), or titanium (Ti). FIG. 11 illustrates that the magnetic memory device 100h includes the orbital Hall conductance layer 132 as a "SOT generation layer", but the magnetic memory device 100h may include the spin Hall conductance layer 133 as the "SOT generation layer". In this case, the spin Hall conductance layer 133 may include platinum (Pt) as a material having a relatively high electrical conductivity and a relatively low electrical resistance.

According to the example embodiment illustrated in FIG. 11, a degree of integration of the plurality of tunneling magnetoresistance layers 120 may be increased. Additionally, write and read may be selectively performed on the plurality of tunneling magnetoresistance layers 120 through a voltage controlled magnetic anisotropy (VCMA). For example, while current is applied to the SOT generation layer, that is, the orbital Hall conductance layer 132 or the spin Hall conductance layer 133, through the second electrode 112 and the third electrode 113, one or more specific tunneling magnetoresistance layers may be selected from the plurality of tunneling magnetoresistance layers 120 according to the voltage applied to the first electrode 111.

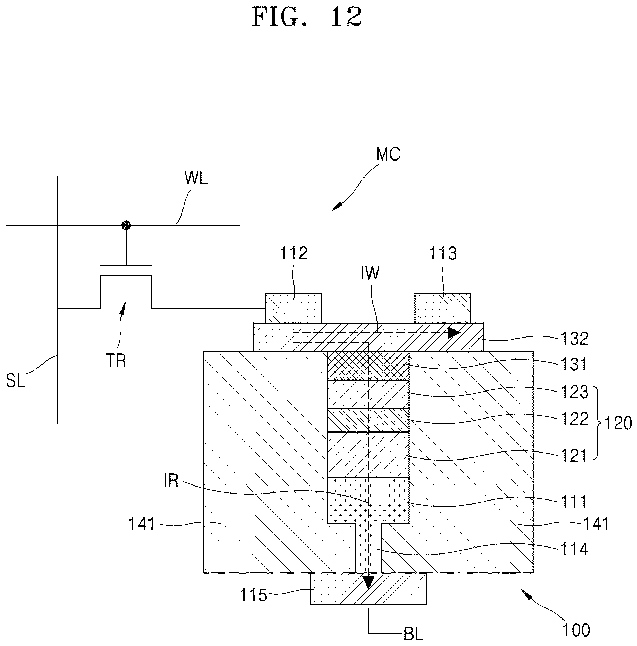

FIG. 12 schematically shows one magnetic memory cell MC including the magnetic memory device 100 according to an example embodiment. Referring to FIG. 12, the memory cell MC may include the magnetic memory device 100 and a switching device TR connected thereto. The switching device TR may be a thin film transistor. The memory cell MC may be connected between a bit line BL and a word line WL. The bit line BL and the word line WL may be disposed to cross each other, and the memory cell MC may be disposed at an intersection of the bit line BL and the word line WL. The bit line BL may be electrically connected to the first electrode 111 of the magnetic memory device 100 through the wiring 115 and the via layer 114, and the word line WL may be connected to a gate of the switching device TR. In addition, a first source/drain electrode of the switching device TR may be electrically connected to the second electrode 112 of the magnetic memory device 100, and a second source/drain electrode may be electrically connected to a source line SL. FIG. 12 illustrates that the memory cell MC includes the magnetic memory device 100 shown in FIGS. 1 and 2, but the memory cell MC in other example embodiments may include one of the magnetic memory devices 100a to 100h shown in FIGS. 3 and 5 to 11.

In this structure, a write current IW or a read current IR may be applied to the memory cell MC through the word line WL, the source line SL, and the bit line BL. For example, when voltage higher than a threshold voltage is applied to the word line WL and current higher than a critical current is applied to the source line SL, the switching device TR may be turned on, and the write current IW may flow through a path between the second electrode 112 and the third electrode 113 of the magnetic memory device 100. At this time, the third electrode 113 of the magnetic memory device 100 may be grounded. Then, a magnetization direction of the free layer 123 may be changed into the +Z direction or the -Z direction according to a direction of current applied to the orbital Hall conductance layer 132.

Meanwhile, the read current IR may flow from the second electrode 112 of the magnetic memory device 100 to the bit line BL through the first electrode 111. For example, when the voltage higher than the threshold voltage is applied to the word line WL and current lower than a critical current is applied to the source line SL, the switching device TR may be turned on, and the read current IR may flow to the bit line BL through the second electrode 112 and the first electrode 111 of the magnetic memory device 100. At this time, the third electrode 113 of the magnetic memory device 100 may be in a floating state. Then, a resistance value of the magnetic memory device 100 may be read by measuring the current flowing through the bit line BL.

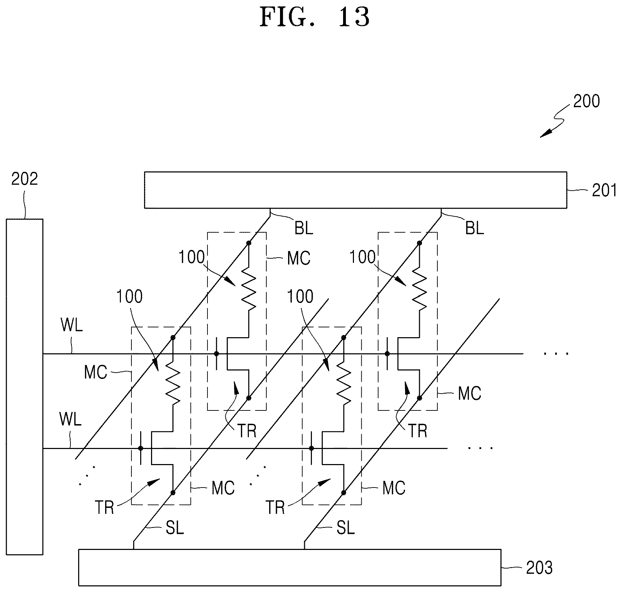

FIG. 13 is a circuit diagram schematically illustrating a configuration of a memory apparatus 200 including the plurality of memory cells MC shown in FIG. 12. Referring to FIG. 13, the memory apparatus 200 may include a plurality of bit lines BL, a plurality of word lines WL, a plurality of source lines SL, the plurality of memory cells MC disposed in intersection points of the plurality of bit lines BL and the plurality of word lines WL, respectively, a bit line driver 201 applying current to the plurality of bit lines BL, a word line driver 202 applying current to the plurality of word lines WL, and a source line driver 203 applying current to the plurality of source lines SL. Each memory cell MC may have the configuration shown in FIG. 12. The memory apparatus 200 shown in FIG. 13 may be, for example, a SOT MRAM, and may be used in electronic devices using a nonvolatile memory.

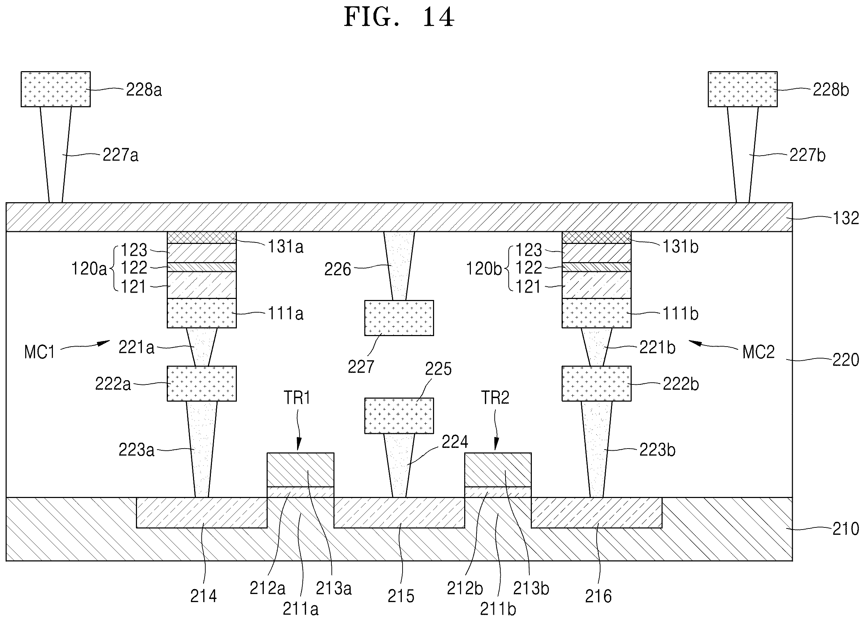

FIG. 14 is a cross-sectional view schematically illustrating a configuration of a memory apparatus 200a according to another example embodiment. Referring to FIG. 14, the memory apparatus 200a may have a structure in which two adjacent memory cells share one source line, one read bit line, and one orbital Hall conductance layer 132. For example, the memory apparatus 200a may include a first memory cell MC1 and a second memory cell MC2. The first memory cell MC1 and the second memory cell MC2 may be configured to share one source line 227, one read bit line 225, and one orbital Hall conductance layer 132.

The first memory cell MC1 may include the orbital Hall conductance layer 132, a first spin current transfer layer 131a provided on a lower surface of the orbital Hall conductance layer 132, a first tunneling magnetoresistance layer 120a provided on a lower surface of the first spin current transfer layer 131a, a first electrode 111a provided on a lower surface of the first tunneling magnetoresistance layer 120a, a second electrode 226 provided on a lower surface of the orbital Hall conductance layer 132, a third electrode 227a provided on an upper surface of the orbital Hall conductance layer 132, a first transistor TR1 electrically connected to the first electrode 111a, a read bit line 225 electrically connected to the first transistor TR1, a source line 227 electrically connected to the second electrode 226, and a first word line 228a electrically connected to the third electrode 227a. For example, the source line 227 may be provided on a lower surface of the second electrode 226. The first word line 228a may be provided on an upper surface of the third electrode 227a.

The first tunneling magnetoresistance layer 120a may include the free layer 123 provided on a lower surface of the first spin current transfer layer 131a, the tunnel barrier layer 122 provided on a lower surface of the free layer 123, and the pinned layer 121 provided on a lower surface of the tunnel barrier layer 122. The first electrode 111a may be electrically connected to the pinned layer 121 of the first tunneling magnetoresistance layer 120a on a lower surface of the pinned layer 121 of the first tunneling magnetoresistance layer 120a.

The first transistor TR1 may include a first source/drain 214, a second source/drain 215, a first channel 211a between the first source/drain 214 and the second source/drain 215, a first gate insulating layer 212a on the first channel 211a, and a first read word line 213a on the first gate insulating layer 212a. The first source/drain 214 may face the first electrode 111a in a vertical direction, and may be electrically connected to the first electrode 111a through a first wiring extending in the vertical direction. The first wiring may include, for example, a first conductive plug 221a, a first contact layer 222a, and a second conductive plug 223a, but example embodiments are not limited thereto. The second source/drain 215 may face the read bit line 225 in the vertical direction, and may be electrically connected to the read bit line 225 through a third conductive plug 224 extending in the vertical direction.

The second memory cell MC2 may include the orbital Hall conductance layer 132, a second spin current transfer layer 131b provided on a lower surface of the orbital Hall conductance layer 132, a second tunneling magnetoresistance layer 120b provided on a lower surface of the second spin current transfer layer 131b, a fourth electrode 111b provided on a lower surface of the second tunneling magnetoresistance layer 120b, a second electrode 226 provided on a lower surface of the orbital Hall conductance layer 132, a fifth electrode 227b provided on an upper surface of the orbital Hall conductance layer 132, a second transistor TR2 electrically connected to the fourth electrode 111b, the read bit line 225 electrically connected to the second transistor TR2, the source line 227 electrically connected to the second electrode 226, and a second word line 228b electrically connected to the fifth electrode 227b. For example, the second word line 228b may be provided on an upper surface of the fifth electrode 227b.

The second tunneling magnetoresistance layer 120b may include the free layer 123 provided on a lower surface of the second spin current transfer layer 131b, the tunnel barrier layer 122 provided on a lower surface of the free layer 123, and the pinned layer 121 provided on a lower surface of the tunnel barrier layer 122. The fourth electrode 111b may be electrically connected to the pinned layer 121 of the second tunneling magnetoresistance layer 120b on a lower surface of the pinned layer 121 of the second tunneling magnetoresistance layer 120b.

The second transistor TR2 may include the second source/drain 215, a third source/drain 216, a second channel 211b between the second source/drain 215 and the third source/drain 216, a second gate insulating layer 212b on the second channel 211b, and a second read word line 213b on the second gate insulating layer 212b. The third source/drain 216 may face the fourth electrode 111b in the vertical direction, and may be electrically connected to the fourth electrode 111b through a second wiring extending in the vertical direction. The second wiring may include, for example, a fourth conductive plug 221b, a second contact layer 222b, and a fifth conductive plug 223b, but example embodiments are not limited thereto.

The first transistor TR1 and the second transistor TR2 may be provided adjacent to each other in a horizontal direction on a substrate 210. The substrate 210 may include a driving circuit for controlling the memory apparatus 200a. The first transistor TR1 and the second transistor TR2 may share the second source/drain 215. For example, the second source/drain 215 may be provided between the first channel 211a and the second channel 211b.

The first memory cell MC1 and the second memory cell MC2 may further share the third conductive plug 224 and the second electrode 226. The orbital Hall conductance layer 132 shared by the first memory cell MC1 and the second memory cell MC2 may extend in the horizontal direction, and the first tunneling magnetoresistance layer 120a and the second tunneling magnetoresistance layer 120b may be adjacent to each other on the lower surface of the orbital Hall conductance layer 132. The third conductive plug 224, the read bit line 225, the second electrode 226, and the source line 227 shared by the first memory cell MC1 and the second memory cell MC2 may be provided between the first tunneling magnetoresistance layer 120a and the second tunneling magnetoresistance layer 120b.

The third electrode 227a and the first word line 228a may be provided on the orbital Hall conductance layer 132 to be spaced apart from the fifth electrode 227b and the second word line 228b. For example, the third electrode 227a and the first word line 228a may be provided at a first side edge on the orbital Hall conductance layer 132, and the fifth electrode 227b and the second word line 228b may be provided at a second side edge opposite the first side edge on the orbital Hall conductance layer 132. For example, the first tunneling magnetoresistance layer 120a may be provided between the third electrode 227a and the second electrode 226 in the horizontal direction. The second tunneling magnetoresistance layer 120b may be provided between the fifth electrode 227b and the second electrode 226 in the horizontal direction.

The memory apparatus 200a may further include an insulating layer 220 filling a space between the first transistor TR1 and the second transistor TR2 and the orbital Hall conductance layer 132. The first tunneling magnetoresistance layer 120a, the second tunneling magnetoresistance layer 120b, the first electrode 111a, the first conductive plug 221a, the first contact layer 222a, the second conductive plug 223a, the fourth electrode 111b, the fourth conductive plug 221b, the second contact layer 222b, the fifth conductive plug 223b, the third conductive plug 224, the read bit line 225, the second electrode 226, and the source line 227 may be buried in the insulating layer 220.

In a write operation on the first memory cell MC1, a voltage may not be applied to the second word line 228b while a write voltage is applied to the first word line 228a. Then, while current flows from the first word line 228a to the source line 227, a write current may be applied to the first memory cell MC1 and no write current may be applied to the second memory cell MC2. In a read operation on the first memory cell MC1, the first transistor TR1 may be turned on by applying voltage higher than a threshold voltage of the first transistor TR1 to the first read word line 213a. A read voltage may be applied to the first word line 228a. Then, a read current may flow from the first word line 228a to the read bit line 225.

In the write operation on the second memory cell MC2, no voltage may be applied to the first word line 228a, and the write voltage may be applied to the second word line 228b. Then, while current flows from the second word line 228b to the source line 227, the write current may be applied to the second memory cell MC2, and no write current may be applied to the first memory cell MC1. In the read operation on the second memory cell MC2, the second transistor TR2 may be turned on by applying voltage higher than a threshold voltage of the second transistor TR2 to the second read word line 213b. The read voltage may be applied to the second word line 228b. Then, the read current may flow from the second word line 228b to the read bit line 225.

FIG. 14 illustrates that the first memory cell MC1 and the second memory cell MC2 include the orbital Hall conductance layer 132 as a "SOT generation layer", but the first memory cell MC1 and the second memory cell MC2 may include the spin Hall conductance layer 133 as the "SOT generation layer". In this case, the spin Hall conductance layer 133 as the "SOT generation layer" may include platinum (Pt) as a material having a relatively high electrical conductivity and a relatively low electrical resistance.

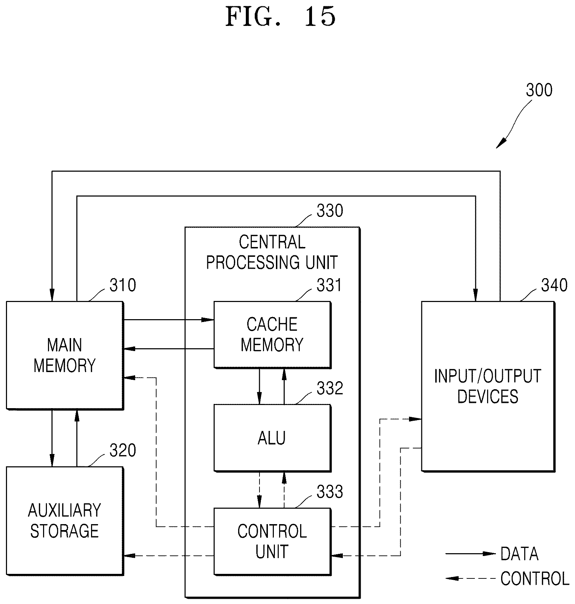

The memory apparatus 200 described above may be used for data storage in various electronic devices. FIG. 15 is a conceptual diagram schematically illustrating a device architecture applicable to an electronic device 300. Referring to FIG. 15, the electronic device 300 may include a main memory 310, an auxiliary storage 320, a central processing unit (CPU) 330, and an input/output device 340. The CPU 330 may include a cache memory 331, an arithmetic logic unit (ALU) 332, and a control unit 333. The cache memory 331 may include static random access memory (SRAM). The main memory 310 may include a DRAM device, and the auxiliary storage 320 may include the memory apparatus 200 according to an example embodiment. In some example embodiments, all of the cache memory 331, the main memory 310, and the auxiliary storage 320 may include the memory apparatus 200 according to an example embodiment.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The example embodiments described above are summarized as follows.
(1) According to an example embodiment, a method of manufacturing a magnetic memory device may include sequentially forming a pinned layer material, a tunnel barrier layer material, a free layer material, and a spin current transfer layer material on an electrode material, forming a mask layer on the spin current transfer layer material, forming a first electrode, a pinned layer, a tunnel barrier layer, a free layer, and a spin current transfer layer by removing the spin current transfer layer material, the free layer material, the tunnel barrier layer material, the pinned layer material, and the electrode material which are exposed by the mask layer through a first etching process, forming an insulating layer to surround side surfaces of the first electrode, the pinned layer, the tunnel barrier layer, the free layer, and the spin current transfer layer and cover a side surface and an upper surface of the mask layer, performing a second etching process until an upper surface of the spin current transfer layer is exposed, and forming a SOT generation layer in contact with the upper surface of the spin current transfer layer.
(2) The method may further include forming a second electrode and a third electrode on the upper surface of the SOT generation layer, the second electrode and the third electrode being spaced apart from each other.
(3) The SOT generation layer may include at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof.
(4) The spin current transfer layer may include platinum (Pt).
(5) The first etching process may be performed through IOE.
(6) The second etching process may include planarizing an upper surface of the insulating layer until the mask layer is exposed, and removing the mask layer through RIE, and additionally planarizing the insulating layer.
(7) According to an example embodiment, a magnetic memory device may include a SOT generation layer configured to generate a SOT, a spin current transfer layer on a lower surface of the SOT generation layer, and a tunneling magnetoresistance layer on a lower surface of the spin current transfer layer and including a free layer, a tunnel barrier layer, and a pinned layer, wherein the spin current transfer layer is configured to transfer a spin current generated from the SOT generation layer to the free layer, the SOT generation layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof, and the spin current transfer layer includes platinum (Pt).
(8) The SOT generation layer may include an orbital Hall conductance layer configured to provide an orbital Hall current due to an OHE, and the orbital Hall conductance layer may include at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), or an alloy thereof.
(9) The orbital Hall conductance layer may include a first orbital Hall conductance layer on the spin current transfer layer and a second orbital Hall conductance layer on the first orbital Hall conductance layer.
(10) The first orbital Hall conductance layer and the second orbital Hall conductance layer may each include at least one material different from each other among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), and alloys thereof.
(11) The SOT generation layer may include a spin Hall conductance layer configured to provide a spin Hall current due to a spin Hall effect (SHE), and the spin Hall conductance layer may include platinum (Pt) or tungsten (βW) having a beta (β) phase.
(12) A thickness of the spin current transfer layer may be about 0.1 nm or more and about 10 nm or less.
(13) The SOT generation layer may include an orbital Hall conductance layer on the spin current transfer layer and configured to provide an orbital Hall current due to an OHE, and a spin Hall conductance layer on the orbital Hall conductance layer and configured to provide a spin Hall current by a SHE.
(14) The SOT generation layer may include a spin Hall conductance layer on the spin current transfer layer and configured to provide a spin Hall current due to a SHE, and an orbital Hall conductance layer on the spin Hall conductance layer and configured to provide an orbital Hall current by an OHE.
(15) The magnetic memory device may further include an oxide layer between the free layer and the spin current transfer layer, and the oxide layer may include at least one of magnesium oxide (MgO), tantalum oxide (TaO), magnesium aluminum oxide (MgAlOₓ), aluminum oxide (AlOₓ), hafnium oxide (HfOₓ), zirconium oxide (ZrOₓ), magnesium tantalum oxide (MgTaOₓ), titanium oxide (TiOₓ), or tungsten oxide (WOₓ).
(16) The magnetic memory device may further include a diffusion barrier metal layer between the free layer and the spin current transfer layer.
(17) The diffusion barrier metal layer may have a single layer or multilayer structure including at least one metal of tantalum (Ta), tungsten (W), iridium (Ir), titanium (Ti), rhenium (Re), cobalt (Co), or an alloy thereof.
(18) The pinned layer may include a first ferromagnetic layer, a second ferromagnetic layer, and an antiferromagnetic coupling layer between the first ferromagnetic layer and the second ferromagnetic layer, and a magnetization direction of the first ferromagnetic layer may be opposite to a magnetization direction of the second ferromagnetic layer.
(19) The magnetic memory device may further include a first electrode electrically connected to the pinned layer, and a second electrode and a third electrode spaced apart from each other on the SOT generation layer.
(20) A plurality of tunneling magnetoresistance layers and a plurality of spin current transfer layers may correspond to one SOT generation layer.
(21) The SOT generation layer may include at least one material among platinum (Pt), iridium (Ir), ruthenium (Ru), or titanium (Ti).
(22) The magnetic memory device may further include a plurality of first electrodes electrically connected to corresponding pinned layers, respectively, among a plurality of pinned layers of the plurality of tunneling magnetoresistance layers, and a second electrode and a third electrode spaced apart from each other on the SOT generation layer.
(23) According to an example embodiment, a memory apparatus may include a plurality of memory cells each including a magnetic memory device and a switching device connected to the magnetic memory device, the magnetic memory device may include a SOT generation layer configured to generate a SOT, a spin current transfer layer on a lower surface of the SOT generation layer, and a tunneling magnetoresistance layer on a lower surface of the spin current transfer layer and including a free layer, a tunnel barrier layer, and a pinned layer, the spin current transfer layer is configured to transfer a spin current generated from the SOT generation layer to the free layer, the SOT generation layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (βW) having a beta (β) phase, or an alloy thereof, and the spin current transfer layer may include platinum (Pt).

The magnetic memory device including the tunneling magnetoresistance layer according to the example embodiment may have a relatively fast operation speed of about 5 nsec or less or 1 about nsec or less. In addition, the magnetic memory device according to the example embodiment may operate at a relatively low current density while having a high operating speed. Therefore, the memory apparatus such as a SOT-MRAM having a relatively high operating speed and a low power consumption may be implemented.

In addition, because the pinned layer is located below the tunnel barrier layer, the PMA of the pinned layer may be easily secured by forming the pinned layer before the tunnel barrier layer in a manufacturing process, and the risk of damage to the pinned layer due to high heat in the subsequent BEOL process may be reduced.

In addition, because the SOT generation layer is formed after an etching process of forming the tunneling magnetoresistance layer in the manufacturing process, there is no risk of a phase of the SOT generation layer being changed by an ion beam in the etching process of forming the tunneling magnetoresistance layer. Additionally, because the substrate or the insulating layer disposed below the tunneling magnetoresistance layer is used as the etch stop layer in the etch process of forming the tunneling magnetoresistance layer, the tunneling magnetoresistance layer may be etched to a sufficient depth, and thus yield may be improved.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A method of manufacturing a magnetic memory device, the method comprising:
sequentially forming a pinned layer material, a tunnel barrier layer material, a free layer material, and a spin current transfer layer material on an electrode material;
forming a mask layer on the spin current transfer layer material;
forming a first electrode, a pinned layer, a tunnel barrier layer, a free layer, and a spin current transfer layer by removing the spin current transfer layer material, the free layer material, the tunnel barrier layer material, the pinned layer material, and the electrode material which are exposed by the mask layer through a first etching process;
forming an insulating layer to surround side surfaces of the first electrode, the pinned layer, the tunnel barrier layer, the free layer, and the spin current transfer layer and to cover a side surface and an upper surface of the mask layer;
performing a second etching process until an upper surface of the spin current transfer layer is exposed; and
forming a spin-orbit torque (SOT) generation layer in contact with the upper surface of the spin current transfer layer.

2. The method of claim 1, further comprising:
forming a second electrode and a third electrode on an upper surface of the SOT generation layer, the second electrode and the third electrode being spaced apart from each other.

3. The method of claim 1 or 2, wherein
the SOT generation layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof, and
the spin current transfer layer includes platinum (Pt).

4. The method of any preceding claim, wherein the first etching process is performed through ion beam etching, IOE.

5. The method of any preceding claim, wherein
the second etching process includes:
planarizing an upper surface of the insulating layer until the mask layer is exposed; and
removing the mask layer through reactive ion etching (RIE), and additionally planarizing the insulating layer.

6. A magnetic memory device comprising:
a spin-orbit torque, SOT, generation layer configured to generate a SOT;
a spin current transfer layer on a lower surface of the SOT generation layer; and
a tunneling magnetoresistance layer on a lower surface of the spin current transfer layer, the tunneling magnetoresistance layer comprising a free layer, a tunnel barrier layer, and a pinned layer,
wherein the spin current transfer layer is configured to transfer a spin current generated from the SOT generation layer to the free layer,
the SOT generation layer comprises at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), platinum (Pt), tungsten (W) having a beta (β) phase, or an alloy thereof, and
the spin current transfer layer comprises platinum (Pt).

7. The magnetic memory device of claim 6, wherein
the SOT generation layer includes an orbital Hall conductance layer configured to provide an orbital Hall current due to an orbital Hall effect (OHE), and
the orbital Hall conductance layer includes at least one material among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), or an alloy thereof, and optionally wherein
the orbital Hall conductance layer includes a first orbital Hall conductance layer on the spin current transfer layer and a second orbital Hall conductance layer on the first orbital Hall conductance layer, and
the first orbital Hall conductance layer and the second orbital Hall conductance layer each include at least one material different from each other among iridium (Ir), manganese (Mn), vanadium (V), chromium (Cr), niobium (Nb), molybdenum (Mo), ruthenium (Ru), tantalum (Ta), tungsten (W), titanium (Ti), rhenium (Re), or alloys thereof.

8. The magnetic memory device of claim 6 or 7, wherein
the SOT generation layer includes a spin Hall conductance layer configured to provide a spin Hall current due to a spin Hall effect (SHE), and
the spin Hall conductance layer includes platinum (Pt) or tungsten (W) having a beta (β) phase.

9. The magnetic memory device of any of claims 6 to 8, wherein a thickness of the spin current transfer layer is 0.1 nm or more and 10 nm or less.

10. The magnetic memory device of any of claims 6 to 9, wherein the SOT generation layer includes an orbital Hall conductance layer on the spin current transfer layer and configured to provide an orbital Hall current due to an OHE, and a spin Hall conductance layer on the orbital Hall conductance layer and configured to provide a spin Hall current by a SHE.

11. The magnetic memory device of any of claims 6 to 10, wherein the SOT generation layer includes a spin Hall conductance layer on the spin current transfer layer and configured to provide a spin Hall current due to a SHE, and an orbital Hall conductance layer on the spin Hall conductance layer and configured to provide an orbital Hall current by an OHE.

12. The magnetic memory device of any of claims 6 to 11, further comprising:
an oxide layer between the free layer and the spin current transfer layer,
wherein the oxide layer includes at least one of magnesium oxide (MgO), tantalum oxide (TaO), magnesium aluminum oxide (MgAlOₓ), aluminum oxide (AlOₓ), hafnium oxide (HfOₓ), zirconium oxide (ZrOₓ), magnesium tantalum oxide (MgTaOₓ), titanium oxide (TiOₓ), or tungsten oxide (WOₓ).

13. The magnetic memory device of any of claims 6 to 12, further comprising:
a diffusion barrier metal layer between the free layer and the spin current transfer layer,
wherein the diffusion barrier metal layer has a single layer or multilayer structure including at least one metal of tantalum (Ta), tungsten (W), iridium (Ir), titanium (Ti), rhenium (Re), cobalt (Co), or an alloy thereof.

14. The magnetic memory device of any of claims 6 to 13, wherein
the pinned layer includes a first ferromagnetic layer, a second ferromagnetic layer, and an antiferromagnetic coupling layer between the first ferromagnetic layer and the second ferromagnetic layer, and
a magnetization direction of the first ferromagnetic layer is opposite to a magnetization direction of the second ferromagnetic layer.

15. A memory apparatus comprising:
a plurality of memory cells each comprising a magnetic memory device according to any of claims 6 to 14 and a switching device connected to the magnetic memory device.
